# EUROPEAN PATENT SPECIFICATION

(11) **EP 1 674 179 B1**
(45) Date of publication and mention of the grant of the patent: **09.04.2008**
(21) Application number: 05445091.1
(22) Date of filing: 29.11.2005
(51) Int. Cl.: B23B 29/04, C23C 14/06

(54) **Tool holders for chip removing machining**
Werkzeughalter zur spanabhebenden Bearbeitung
Supports d'outils à enlèvement de copeaux

(30) Priority: 22.12.2004 SE 0403174
(43) Date of publication of application: 28.06.2006
(60) Divisional application: 08101838.4
(73) Proprietor: Sandvik Intellectual Property AB, 811 81 Sandviken (SE)
(72) Inventor: Ahlgren, Mats, 187 67 Täby (SE)
(74) Representative: Taquist, Henrik Lennart Emanuel

(56) References cited:
- JP-A- 8 267 306
- PATENT ABSTRACTS OF JAPAN vol. 2003, no. 12, 5 December 2003 (2003-12-05) & JP 2004 299023 A (MITSUBISHI MATERIALS CORP), 28 October 2004 (2004-10-28)
- NAKAMOTO KAZUNARI ET AL: "Development of colored stainless steel sheets by ceramics coating" ISIJ INT; ISIJ INTERNATIONAL 1993, vol. 33, no. 9, 1993, pages 968-975, XP008062826

## Description

The present invention relates to tool holders for chip removing machining provided with an outermost thin interference colour layer.

By a tool holder, is in this application meant a holder for one or more cutting inserts for chip removing machining. The holder includes a base body on which at least one insert-receiving seat or other arrangement for receiving a cutting insert is disposed. For turning applications the tool holders are generally of an elongated shape and for milling applications rotational symmetric. The inserts are made of cemented carbide, cermet, ceramics, high-speed steel, tool steel or the superhard materials such as cubic boron nitride or diamond.

The holders are made from tool steel and manufactured by conventional chip removing machining methods to desired shape and dimension. After that the surface is treated in order to obtain a surface of black oxide. Finally, the surface is oiled to further protect it.

It would of course be very useful if tool holders could be given different colours as a guide to the end user to select the correct one for a certain machining operation but also for decorative reasons. Unfortunately, the number of coloured compounds suitable for such purpose is limited. One method, which is often used, is anodization. Another possibility would be to use Physical Vapour Deposition (PVD).

Nakamoto et al., "Development of Colored Stainless Steel Sheets by Ceramics Coating", ISIJ INT; ISIJ INTERNATIONAL 1993, vol. 33, no. 9, 1993 (pp 968-975), discloses ceramic coatings, such as TiN, TiAlN and TiAlCN on stainless steel sheets, wherein the coated sheets have an attractive colour apperance.

It is an object of the present invention to provide a tool holder with different colours as a guide to the end user to select the correct one for a certain machining operation.

It is a further object of the present invention to provide a tool holder with a colouring layer with increased wear resistance.

It is a still further object of the present invention to provide a tool holder with a colouring layer that easily can be deposited.

It is yet another object of the present invention to provide a tool holder with a colour that is consistent within a charge as well as between charges.

According to the present invention a tool holder is provided coloured by an outermost thin transparent non-oxide layer. Its thickness is such that it is coloured by interference, i.e., a thickness of 0.05 - <0.2 µm. The body consists of tool steel.

The colour layer may be the only layer but it may also be on top of a wear resistant functional coating. Preferably said colour layer is in contact with a TiN-layer, with a thickness of 0.1 - 5.0 µm.

Said colour layer is TiₓAl₁₋ₓN with 0.4<x<0.7, preferably 0.4<x<0.6.

Preferably, said layer is blue with -20<a*<0, -40<b*<0 and 0<L*<95. In one preferred embodiment -20<a*<-10. In another preferred embodiment -40<b*<-20. The a*, b* and L* coordinates are well-known in the art as part of the CIELab system, a uniform device independent colour space in which colours are located within a three-dimensional rectangular coordinate system. The three dimensions are lightness (L*), redness/greenness (a*) and yellowness/blueness (b*).

The layers are deposited by PVD-technique, preferably by magnetron sputtering or cathodic arc evaporation. Said layers are easily deposited in a production scale equipment in situ with the same set-up as used for the functional wear resistant layers.

Said colour layers can also be deposited with Plasma Assisted Chemical Vapour Deposition (PACVD).

### Example 1

End mill tool holders were provided with a blue outer coating by a sputtering process. A foil 20x20 mm² large in the shape of a cylinder was coated at the same time. Both the tool holders and the foil were subject to the same 3-fold rotation. Ar, Kr and N₂ flow were regulated to 150, 85 and 70 sccm respectively. A negative substrate bias of 100 V was applied. First, a TiN layer of about 0.2 µm was deposited. On top of this TiN-layer a (Ti_{0.5}Al_{0.5})N layer was deposited using two Ti_{0.5}Al_{0.5}-targets as metal sources. By depositing the (Ti_{0.5}Al_{0.5})N layer for 23 minutes with a cathode power of 3.2 kW on each Ti_{0.5}Al_{0.5}-target a nice blue colour was obtained. The L*, a* and b* values were measured on the foil using a Minolta Spectrophotometer CM-2500D with the following settings:

| | |
|---|---|
| Mask/Gloss | M/SCI |
| UV Setting | UV 100% |
| Illuminant1 | D65 |
| Observer | 10° |
| Display | DIFF & ABS. |

The following results were obtained: a*= -16, b*= -30 and L*=39.

### Example 2

Example 1 was repeated but by depositing (Ti,Al)N for 23 minutes with a cathode power of 3.7 kW on each Ti_{0.5}Al_{0.5}-target. A blue colour was obtained with the following results: a*= -18, b*= - 23 and L*= 46.

### Example 3

Example 1 was repeated but by depositing (Ti,Al)N for 23 minutes with a cathode power of 5.7 kW on each Ti_{0.5}Al_{0.5}-target. A green colour was obtained with the following results: a*= -14, b*= -7 and L*= 56.

### Example 4

Example 1 was repeated but Ar, Kr, and N₂ flows were changed to 250, 150 and 70 sccm respectively and depositing (Ti,Al)N for 23 minutes with a cathode power of 3.2 kW on each Ti_{0.5}Al_{0.5}-target. A deep blue colour was obtained with the following results: a*= -3, b*= -39 and L*= 29.

### Example 5

Example 4 was repeated in its entirety after some time. Again a deep blue colour was obtained with the following results: a*= -5, b*= -37 and L*= 31.

## Claims

1. Tool holder with a thin outermost colouring non-oxide layer **characterized in that** said colour is created by interference and **in that** said layer is TiₓAl₁₋ₓN with 0.4<x<0.7 and **in that** the layer thickness is 0.05-<0.2 µm.

2. Tool holder according to claim 1 **characterized in that** 0.4<x<0.6.

3. Tool holder according to claim 1 **characterized in** said layer is blue with -20<a*<0, -40<b*<0 and 0<L*<95, when a*, b* and L* are coordinates of the CIEL ab system.

4. Tool holder according to any of the preceding claims **characterized in** said layer is deposited on top of a TiN-layer, preferably 0.1-5 µm thick.

## Patentansprüche

1. Werkzeughalter mit einer dünnen äußeren farbgebenden Nicht-Oxid-Lage, **dadurch gekennzeichnet, daß** die Farbe durch interferenz erzeugt wird und daß die Lage TiₓAl₁₋ₓN mit 0,4 < x < 0.7 ist und daß die Lagendicke 0,05 bis < 0,2 µm beträgt.

2. Werkzeughalter nach Anspruch 1, **dadurch gekennzeichnet, daß** 0.4 < x < 0,6 ist.

3. Werkzeughalter nach Anspruch 1, **dadurch gekennzeichnet, daß** die Lage blau ist mit -20 < a* < 0, -40 < b* < 0 und 0 < L* < 95, wobei a*, b* und L* Koordinaten des CIEL-ab-Systems sind.

4. Werkzeughalter nach einem der vorangegangenen Ansprüche, **dadurch gekennzeichnet, daß** die Lage auf einer TIN-Lage, die vorzugsweise 0,1-5 µm dick ist, abgeschieden ist.

## Revendications

1. Porte-outil comportant une fine couche colorante non oxyde externe **caractérisé en ce que** ladite couleur est créée par interférence et **en ce que** ladite couche est TiₓAl₁₋ₓN avec 0, 4 x < 0,7 et **en ce que** l'épaisseur de la couche est de 0,05- < 0,2 µm.

2. porte-outil selon la revendication 1, **caractérisé en ce que** 0,4 < x < 0,6.

3. porte-outil selon la revendication 1, **caractérisé en ce que** ladite couche est bleue avec -20 < a* < 0, -40 < b* < 0 et 0 < L* < 95 où a*, b* et L* sont des coordonnées du système CIEL ab.

4. Porte-outil selon l'une quelconque des revendications précédentes, **caractérisé en ce que** ladite couche est déposée au-dessus d'une couche de TiN, de préférence d'une épaisseur de 0,1 à 5 µm.
